(19) **Europäisches Patentamt / European Patent Office / Office européen des brevets**

(11) **EP 3 388 855 B1**

(12) **EUROPÄISCHE PATENTSCHRIFT**

(45) Veröffentlichungstag und Bekanntmachung des Hinweises auf die Patenterteilung:
**28.08.2024 Patentblatt 2024/35**

(21) Anmeldenummer: **17166289.3**

(22) Anmeldetag: **12.04.2017**

(51) Internationale Patentklassifikation (IPC):
***G01R 33/36*** (2006.01)

(52) Gemeinsame Patentklassifikation (CPC):
**G01R 33/3692**

(54) **VORRICHTUNG UND VERFAHREN ZUR RÜCKGEWINNUNG DES ZEITLICHEN BEZUGES IN FREILAUFENDEN MR-EMPFANGSKETTEN**

DEVICE AND METHOD FOR THE RECOVERY OF TIME-RELATED REFERENCES IN FREE RUNNING MR RECEPTION CHAINS

DISPOSITIF ET PROCÉDÉ DE RÉCUPÉRATION DE LA RÉFÉRENCE TEMPORELLE DANS DES CHAÎNES DE RÉCEPTION À RM LIBRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.10.2018 Patentblatt 2018/42**

(73) Patentinhaber: **Siemens Healthineers AG**
**91301 Forchheim (DE)**

(72) Erfinder:
- **Nisznansky, Martin**
  **91096 Möhrendorf (DE)**
- **Biber, Stephan**
  **91056 Erlangen (DE)**

- **Bollenbeck, Jan**
  **91330 Eggolsheim (DE)**
- **Heggen, Sven**
  **91056 Erlangen (DE)**
- **Vester, Markus**
  **90471 Nürnberg (DE)**

(74) Vertreter: **Siemens Healthineers Patent Attorneys**
**Postfach 22 16 34**
**80506 München (DE)**

(56) Entgegenhaltungen:
WO-A1-2015/197720     DE-A1- 102011 006 509
US-A1- 2011 109 316     US-B1- 7 123 009

EP 3 388 855 B1

## Beschreibung

Die Erfindung betrifft eine Vorrichtung und ein Verfahren zur Rückgewinnung des zeitlichen Bezuges in einer freilaufenden MRT-Empfangskette.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Antennen, sogenannte Lokalspulen verwendet, die zur Erzielung eines besseren Signal-Rauschabstandes unmittelbar am Untersuchungsobjekt angeordnet werden.

Die Resonanzfrequenz der Kernspins, auch als Larmor-Frequenz bezeichnet, ist direkt proportional zu einem äußeren statischen bzw. quasistatischen Magnetfeld, das sich aus dem statischen Magnetfeld B0 und den Gradientenfeldern zusammensetzt.

Für die Bildgebung sind Frequenz und Phase des empfangenen Magnetresonanzsignals relevant und müssen in Bezug auf die zur Anregung der Präzession ausgesendeten Pulse und untereinander bei mehreren parallelen Empfängern genau eingehalten werden. Üblicherweise werden daher alle ausgesendeten Signale von einem zentralen Referenztakt durch Frequenzteilung, Vervielfältigung oder Mischung abgeleitet. Das gleiche gilt für Misch- oder Sample-Frequenzen auf dem Empfangsweg, sodass ein fester Phasen- und Frequenzbezug auf der ganzen Signalkette besteht. Dafür ist es jedoch erforderlich, allen Einheiten entsprechende Referenzsignale zuzuführen, was insbesondere bei Lokalspulen zu dickeren und unhandlichen Kabeln führt.

Das Dokument DE 10 2013 204705 beschreibt einen Magnetresonanztomographen mit drahtloser Übertragung von Daten von der Lokalspule zu einer MRT-Basis.

Aus dem Dokument DE 10 2011 076918 sind eine Sendeeinrichtung, ein Magnetresonanzsystem und ein Verfahren zur drahtlosen Energieübertragung zu einem Lokalspulensystem bekannt.

Das Dokument DE 10 2012 210827 offenbart ein Verfahren und eine Vorrichtung zum Bestimmen einer Kommunikationslatenz in einem Magnetresonanztomographen.

Aus dem Dokument US 2011/0109316 A1 sind eine Steuereinheit und eine Lokalspuleneinheit bekannt. Die Kontrolleinheit stellt ein Taktsignal und Steuersignale bereit, moduliert das Taktsignal mit dem Steuersignal und überträgt das Ergebnis mittels eines Trägersignals an die Lokalspuleneinheit. Die Lokalspuleneinheit erfasst das Trägersignal, synchronisiert mit dem Taktsignal einen lokalen Taktgeber und digitalisiert das Magnetresonanzsignal mit dem Signal des lokalen Taktgebers als Abtasttakt.

Das Dokument US 7123009 B1 beschreibt ein Magnetresonanzsystem mit einer Lokalspule zum Empfang und einer Computereinheit zur Verarbeitung eines Magnetresonanzsignals. Phasenfehler, die durch die Lokalspule verursacht werden, werden durch die Computereinheit korrigiert, indem ein Pilotton von der Computereinheit erzeugt und zur Lokalspule gesendet wird und anschließend gemeinsam mit dem Magnetresonanzsignal von der Computereinheit verarbeitet werden, sodass durch die Kombination von Pilotton und Magnetresonanzsignal die Phasenfehler erkannt und korrigiert werden.

Ein vergleichbares System zur Phasenkorrektur mittels Pilotton, das eine Amplitudenmodulation mit Trägerunterdrückung verwendet, ist aus dem Dokument WO 2015/197720 bekannt.

Das Dokument DE 10 2011 006 509 A1 offenbart schließlich eine Lokalspule mit drahtloser Datenübertragung, bei der zur Vermeidung von Frequenzstörungen durch zufällige Bitfolgen mit vielen aufeinanderfolgenden gleichen Bitzuständen vorgeschlagen wird, die Daten mit einer Pseudozufallszahlenfolge zu verändern.

Es stellt sich daher die Aufgabe, ein MRT-System mit vereinfachter Handhabung bereitzustellen.

Die Aufgabe wird durch einen erfindungsgemäßen Magnetresonanztomographen mit einer Vorrichtung zur Rückgewinnung des zeitlichen Bezuges in einer freilaufenden MRT-Empfangskette nach Anspruch 1, und ein erfindungsgemäßes Verfahren nach Anspruch 10 gelöst.

Der erfindungsgemäße Magnetresonanztomograph nach Anspruch 1 weist eine Vorrichtung zur Rückgewinnung des zeitlichen Bezuges in einer freilaufenden MRT-Empfangskette und einen Zeitreferenzencoder mit einem ersten Signalausgang auf. Der Zeitreferenzencoder ist ausgelegt, ein Modulationssignal zur Modulation einer Trägerwelle in Abhängigkeit von einem Referenztakt zu erzeugen und über den ersten Signalausgang auszugeben. Der Referenztakt für den zeitlichen Bezug wird durch einen zentralen Taktgeber des Magnetresonanztomographen bereitgestellt. Das Modulationssignal ist für eine Korrelation mit einem Referenzsignal mit einer zeitlichen Auflösung kleiner einer maximalen vorbestimmten Phasenabweichung ausgelegt. Dies wird dadurch erreicht, dass das Modulationssignal und das Referenzsignal jeweils einen Basistakt bzw. Grundfrequenzkomponente aufweist, deren Periodendauer kleiner oder gleich der maximal vorbestimmten Phasenabweichung ist, also erfindungsgemäß kleiner als 1 Mikrosekunde, vorzugsweise kleiner als 100 Nanosekunden, 10 Nanosekunden oder 1 Nanosekunde. Weiterhin weist das Modulationssignal bei einer Korrelation mit dem Referenzsignal ein eindeutig zu identifizierendes Maximum auf. Dabei ist das eindeutig zu identifizierende Maximum so zu verstehen, dass die nachfolgend in der Figurenbeschreibung dargelegte Korrelation ein Maximum aufweist, wenn das Modulationssignal und das Referenzsignal zeitlich zueinander übereinstimmen bzw. in Phase sind, und dieses Maximum gegenüber Nebenmaxima, die bei einem zeitlichen Versatz des Modulationssignals zu dem Referenzsignal auftreten können, ausgezeichnet ist, erfindungsgemäß durch eine größere Amplitude, die mehr als 6 dB oder vorzugsweise 12 dB über dem bzw. den Pegeln des bzw. der Nebenmaxima liegt. Vorzugsweise ist der Pegel des Maximums auch mehr als 3 dB, 6 dB, 12 dB, oder 18 dB über einem Rauschpegel, der durch die Korrelation im Fall eines zufälligen Eingangssignals anstelle des Modulationssignals erzeugt wird. Ein derartiges scharfes und im Pegel herausragendes Maximum wird erfindungsgemäß durch eine ausreichende Länge des jeweiligen Signals erreicht, wobei das Signal erfindungsgemäß länger als 10 Perioden des Basistakts bzw. Pegelwechsels ist. Vorzugsweise ist das Signal länger als 20, 50 oder 100 Perioden des Basistakts bzw. Pegelwechsels. Beispiele für mögliche Modulationssignale bzw. deren Erzeugung sind in den abhängigen Ansprüchen angegeben. Der Zeitreferenzcoder kann beispielsweise in einem Logikchip oder einem Prozessor realisiert sein.

Der erfindungsgemäße Magnetresonanztomograph weist eine Sendeantenne zum Aussenden der Trägerwelle und eine Empfangsantenne und einen Empfänger auf, der zum Empfang der Trägerwelle und zum Erzeugen des Empfangssignals ausgelegt ist. Der Empfänger steht in Signalverbindung mit dem Zeitreferenzdecoder und ist ausgelegt, dem ersten Signaleingang des Zeitreferenzdecoders das Empfangssignal zuzuführen.

Der erfindungsgemäße Magnetresonanztomograph ist ausgelegt, über den Empfänger ein Magnetresonanzsignal zur Bildgebung aufzunehmen.

Weiterhin weist der erfindungsgemäße Magnetresonanztomograph einen Zeitreferenzdecoder mit einem ersten Signaleingang auf. Der erste Signaleingang ist ausgelegt, ein Empfangssignal in Abhängigkeit von dem Modulationssignal zu empfangen. Erfindungsgemäß stammt das Empfangssignal von dem Empfänger, der die mit dem Modulationssignal des Zeitreferenzcoders modulierte Trägerwelle empfängt. Der Zeitreferenzdecoder ist ausgelegt, eine Korrelation mit dem Referenzsignal auszuführen und ein Signal in Abhängigkeit von einer zeitlichen Beziehung des Modulationssignals in dem Empfangssignal zu dem Referenzsignal zu generieren. Das Referenzsignal kann im einfachsten Fall das im Zeitreferenzcoder verwendete oder ein davon abgeleitetes Signal sein, das dem Zeitreferenzdecoder über einen zweiten Signaleingang zugeführt wird. Der Zeitreferenzdecoder ist dann ausgelegt, ein Signal in Abhängigkeit von einer Verzögerung des Empfangssignals zu dem Referenzsignal zu generieren.

Es ist aber auch denkbar, dass der Zeitreferenzdecoder das Modulationssignal in einem Speicher gespeichert hat oder mit einer identischen Struktur wie im Zeitreferenzencoder erzeugt. In diesem Fall könnte der Zeitreferenzdecoder ausgelegt sein, ein Signal in Abhängigkeit eines Fortschritts des im Empfangssignal modulierten Modulationssignals in Bezug auf das Referenzsignal zu generieren, beispielsweise über die Adresse oder Zähler der Speicherzelle des gespeicherten Referenzsignals, die dem gerade vorliegenden Schritt im empfangenen Modulationssignal entspricht.

Dabei ist es denkbar, dass der erfindungsgemäße Zeitreferenzdecoder das generierte Signal entweder über einen zweiten Signalausgang ausgibt oder intern bei der Verarbeitung des Empfangssignals nutzt, beispielsweise das Empfangssignal in Abhängigkeit von der zeitlichen Beziehung zu dem Referenztakt modifiziert, indem z.B. eine Zeitinformation zu dem Empfangssignal hinzugefügt wird oder das Empfangssignal um eine von dem generierten Signal abhängige Dauer verzögert wird.

Auf vorteilhafte Weise ermöglicht die erfindungsgemäße Vorrichtung, einen Zeitbezug mit einem Hochfrequenzsignal zu übermitteln und anschließend diesen Zeitbezug auszuwerten, sodass ohne zusätzliche Verteilung von Referenztakten an alle beteiligten Elemente der MR-Empfangskette ein Frequenz- und Phasenbezug hergestellt werden kann. Es ist auf diese Weise auch möglich, die Empfangskette zu ändern oder verschiedenen Empfangskanälen unterschiedlich auszuführen, ohne jeweils eine externe Kalibrierung ausführen zu müssen.

Das erfindungsgemäße Verfahren teilt die Vorteile der erfindungsgemäßen Vorrichtung.

Weitere vorteilhafte Ausführungsformen sind in den Unteransprüchen angegeben.

In einer möglichen Ausführungsform des erfindungsgemäßen Magnetresonanztomographen weist der Zeitreferenzencoder einen Pseudozufallsfolgengenerator (pseudo-random binary sequence generator, PRBS generator) auf.

Ein Pseudozufallsfolgengenerator bietet auf vorteilhafte Weise eine einfache Möglichkeit, ein Modulationssignal für eine Korrelation bereitzustellen.

In einer denkbaren Ausführungsform weist der Pseudozufallsfolgengenerator eine Schieberegisterlogik mit linearer Rückkopplung auf.

Eine Schieberegisterlogik mit linearer Rückkopplung bietet eine besonders einfach Möglichkeit zur Erzeugung von Pseudozufallsfolgen, die von einem Startwert abhängen.

In einer möglichen Ausführungsform des erfindungsgemäßen Magnetresonanztomographen ist der Pseudozufallsfolgengenerator ausgelegt, eine Gold-, Kasami- oder JPL-Folge zu erzeugen. Die genannten Pseudozufallsfolgen weisen bei der Korrelation besonders vorteilhafte Eigenschaften wie eine schnelle Konvergenz und/oder ein scharfes Maximum bei Konvergenz der Korrelation auf.

In einer denkbaren Ausführungsform des erfindungsgemäßen Magnetresonanztomographen weist der Zeitreferenzdecoder einen PLL-gesteuerten frequenzvariablen Oszillator auf. Der Oszillator ist dabei ausgelegt, mittels der Phasenrückkoppelschleife ein Taktsignal des Pseudozufallsgenerators aus dem Empfangssignal zurückzugewinnen. Denkbar ist dabei sowohl eine Implementierung in analoger Bauweise als auch digital durch Logikschaltungen oder als Programm in einer digitalen Signalverarbeitung.

Auf vorteilhafte Weise ist es aufgrund der durch die Korrelation bestimmten Phasenlage auch möglich, den frequenzvariablen Oszillator mit einem dem Pseudozufallscode bei der Erzeugung zugrundeliegenden Taktsignal zu synchronisieren und das Taktsignal im Empfänger mit synchroner Frequenz und definierter Phasenlage bereitzustellen.

Weiterhin weist der Magnetresonanztomograph eine zentrale Takterzeugung auf, wobei der Referenzsignaleingang des Zeitreferenzencoders mit dem zentralen Takterzeuger in Signalverbindung steht, um einen Referenztakt zu erhalten. Der Magnetresonanztomograph weist auch einen Hochfrequenzgenerator auf, der ausgelegt ist, eine Trägerwelle in Abhängigkeit von dem zentralen Taktgeber zu erzeugen und in Abhängigkeit von dem Modulationssignal zu modulieren.

Durch den zentralen Taktgeber wird auf vorteilhafte Weise sichergestellt, dass unterschiedliche Vorgänge des Magnetresonanztomographen synchron zu einander und mit gleichem Frequenzverhältnis laufen, sodass eine gegenseitige Störung z.B. durch Oberwellen ausgeschlossen wird. Der Hochfrequenzgenerator nutzt dabei auch die bessere Frequenzstabilität der zentralen Takterzeugung.

In einer möglichen Ausführungsform des erfindungsgemäßen Magnetresonanztomographen weist die Trägerwelle eine Frequenz auf, die in einem Frequenzbereich einer Larmorfrequenz des Magnetresonanztomographen liegt, insbesondere der Larmorfrequenz eines Wasserstoffkerns.

Als Trägerwelle wird hierbei das Hochfrequenzsignal angesehen, welches abschließend mit einer Antenne abgestrahlt wird, um die mit dem Modulationssignal aufgeprägte Sequenz zu einem Empfänger zu übertragen. Dabei wird es als Modulation der Trägerwelle im Sinne der Erfindung auch angesehen, wenn zunächst ein Hochfrequenzsignal mit einer Frequenz ungleich der Frequenz der Trägerwelle moduliert wird und anschließend daraus durch Mischung oder Frequenzvervielfachung dann die Trägerwelle erzeugt wird.

Auf vorteilhafte Weise nutzt die Trägerwelle den Frequenzbereich der Larmorfrequenz des Magnetresonanztomographen, die auch zur Bildgebung mittels Kernspinresonanz genutzt wird, sodass Teile des Magnetresonanztomographen gemeinsam für Bildgebung und Zeitreferenzsignal genutzt werden können. Als Frequenzbereich wird dabei der Bereich an Frequenzen bezeichnet, den die Empfänger des Magnetresonanztomographen zur Bildgebung nutzen und verarbeiten können. Der Bereich kann dabei von der Larmorfrequenz bei einer Magnetfeldstärke B0, gegeben durch einen Feldmagneten des Magnetresonanztomographen, um mehr als 0,5%, 1% oder 2% oder um 0,5 MHz, 1 MHz oder 2 MHz abweichen. Für die Definition der Grenzen des Bereichs werden die Frequenzen herangezogen, bei denen eine Dämpfung eines eingehenden Hochfrequenzsignals gegenüber einer Stärke bei der Larmorfrequenz um beispielsweise nicht mehr als 3 dB, 6 dB oder 12 dB erfolgt. Die Larmorfrequenz ist dabei vorzugsweise die Resonanzfrequenz des Spins eines Wasserstoffkerns im Magnetfeld B0, kann aber auch Larmorfrequenzen anderer zu untersuchender Elemente umfassen.

Die Nutzung des Frequenzbereichs um die Larmorfrequenz ermöglicht es auf vorteilhafte Weise, ein Signal mit der modulierten Trägerwelle mit der MR-Empfangskette, die auch für die Bildgebung genutzt wird, zu empfangen und auszuwerten. So kann insbesondere auch die Phasen- und Frequenzbeziehung bzw. Verzögerung der Empfangskette ermittelt werden und/oder ein Taktsignal an unterschiedliche Einheiten drahtlos übertragen werden.

In einer denkbaren Ausführungsform des Magnetresonanztomographen ist der Hochfrequenzgenerator ausgelegt, die Trägerwelle mit dem Modulationssignal mittels einer Frequenzspreizungsmodulation zu modulieren. Ein mögliches Beispiel für eine Frequenzspreizungsmodulation ist CDMA (code division multiple access), denkbar sind aber auch beispielsweise DSSS (direct sequence spread spectrom), FHSS (frequency hopping spread spectrum) oder CSS (chirp spread spectrum). Vorzugsweise ist dabei der Pegel der modulierten Trägerfrequenz unter einem Rauschpegel des MRT-Signals.

Auf vorteilhafte Weise erlaubt eine Frequenzspreizungsmodulation, zur Übertragung des Modulationssignals eine Trägerwelle im Bereich der Larmorfrequenz zu verwenden, sodass für die Übertragung des Modulationssignals ein Frequenzbereich verwendet wird, der ganz oder teilweise mit dem für die bildgebenden Messungen verwendeten Frequenzbereich der MRT-Signale überlappt. Durch die Frequenzspreizungsmodulation ist es möglich, Signalpegel der Trägerwelle zu nutzen, die unter der Rauschgrenze des MRT-Signals liegen und dennoch detektiert werden können und/oder aufgrund der bekannten Struktur des Signals der Trägerwelle dieses aus dem Empfangssignals ganz oder teilweise zu entfernen.

In einer denkbaren Ausführungsform des Magnetresonanztomographen weist der Magnetresonanztomograph eine Lokalspule mit einem erfindungsgemäßen Zeitreferenzdecoder auf. Denkbar ist insbesondere auch ein Zeitreferenzdecoder mit PLL und frequenzvariablem Oszillator.

Auf vorteilhafte Weise ermöglicht es der Zeitreferenzdecoder, für eine Lokalspule einen Zeitbezug herzustellen, ohne drahtgebunden einen Referenztakt zuführen zu müssen. Insbesondere ist es auch denkbar, beispielsweise mittels eines PLL-gesteuerten VFO (variable frequency oszillator) eine hochgenaue Frequenz mit vorbestimmter Phasenbeziehung für ein Heruntermischen auf eine ZF oder eine direkte Digitalisierung bereitzustellen.

In einer möglichen Ausführungsform des Magnetresonanztomographen weist der Magnetresonanztomograph eine Mehrzahl an Empfängern zum Empfang eines Magnetresonanzsignals auf sowie eine Mehrzahl an Zeitreferenzdecodern in Signalverbindung mit jeweils einem Empfänger.

Auf vorteilhafte Weise erlaubt es der Zeitreferenzdecoder in den einzelnen Empfängern, auch für unterschiedliche Empfangswege die Signalwege zu synchronisieren und eine eindeutige Phasenbeziehung zu ermitteln. So können z.B. unterschiedliche Spulentypen und Signalaufbereitungen variabel gemischt werden und gleichzeitig die Zeitverzögerung transparent festgestellt und berücksichtigt werden, ohne manuell einzugreifen oder die Eigenschaften geänderter Signalwege im Einzelnen eingeben zu müssen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:

Fig. 1 eine beispielhafte schematische Darstellung eines erfindungsgemäßen Magnetresonanztomographen mit einer erfindungsgemäßen Vorrichtung zur Rückgewinnung des zeitlichen Bezuges in einer freilaufenden MRT-Empfangskette;

Fig. 2 ein schematisches Funktionsdiagramm einer erfindungsgemäßen Ausführungsform einer Vorrichtung zur Rückgewinnung des zeitlichen Bezuges in einer freilaufenden MRT-Empfangskette;

Fig. 3 ein schematisches Funktionsdiagramm einer anderen möglichen Ausführungsform einer erfindungsgemäßen Vorrichtung zur Rückgewinnung des zeitlichen Bezuges in einer freilaufenden MRT-Empfangskette;

Fig. 4 einen schematischen Ablaufplan eines erfindungsgemäßen Verfahrens zur Rückgewinnung des zeitlichen Bezuges in einer freilaufenden MRT-Empfangskette.

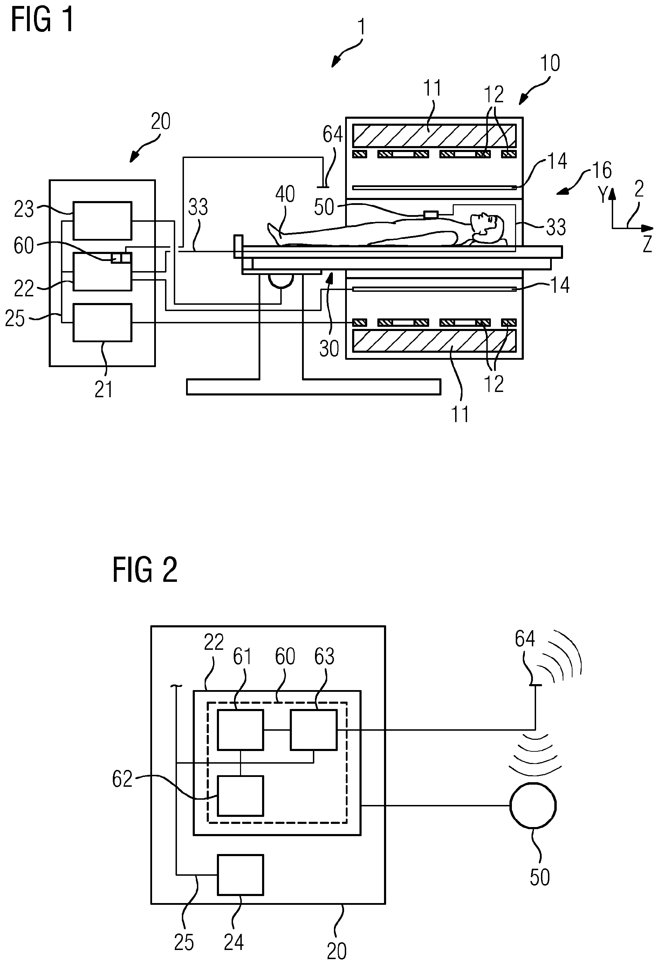

Fig. 1 zeigt eine schematische Darstellung einer Ausführungsform eines erfindungsgemäßen Magnetresonanztomographen 1 mit einer Vorrichtung 60 zur Rückgewinnung des zeitlichen Bezuges in einer freilaufenden MRT-Empfangskette.

Die Magneteinheit 10 weist einen Feldmagneten 11 auf, der ein statisches Magnetfeld B0 zur Ausrichtung von Kernspins von Proben bzw. Patienten 40 in einem Aufnahmebereich erzeugt. Der Aufnahmebereich ist in einem Patiententunnel 16 angeordnet, der sich in einer Längsrichtung 2 durch die Magneteinheit 10 erstreckt. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung 33 zugeführtes Hochfrequenzsignal in das Untersuchungsvolumen abzustrahlen und von dem Patient 40 emittierte Resonanzsignale zu empfangen und über eine Signalleitung abzugeben. Bevorzugter Weise wird aber die Körperspule 14 für das Aussenden des Hochfrequenzsignals und/oder das Empfangen durch Lokalspulen 50 ersetzt, die in dem Patiententunnel 16 nahe am Patient 40 angeordnet sind. Es ist aber auch denkbar, dass die Lokalspule 50 zum Senden und Empfangen ausgelegt ist und deshalb eine Körperspule 14 entfallen kann.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 40 zu erzeugen. Dabei können Pulsleistungen im Bereich von Kilowatt erreicht werden. Die einzelnen Einheiten sind über einen Signalbus 25 untereinander verbunden.

Das von der Hochfrequenzeinheit 22 erzeugte Hochfrequenzsignal wird über eine Signalverbindung 33 der Patientenliege 30 zugeführt und an eine oder mehrere Lokalspulen 50 verteilt und in den Körper des Patienten 40 ausgesendet, um dort die Kernspins anzuregen. Denkbar ist aber auch ein Aussenden des Hochfrequenzsignals über die Körperspule 14.

Die Lokalspule 50 empfängt dann vorzugsweise ein Magnetresonanzsignal aus dem Körper des Patienten 40, denn aufgrund des geringen Abstandes ist das Signal-zu-Rauschverhältnis (SNR) der Lokalspule 50 besser als bei einem Empfang durch die Körperspule 14. Das von der Lokalspule 50 empfangene MR-Signal wird in der Lokalspule 50 aufbereitet und an die Hochfrequenzeinheit 22 des Magnetresonanztomographen 1 zur Auswertung und Bilderfassung weitergeleitet. Vorzugsweise wird dazu ebenfalls die Signalverbindung 33 genutzt, es sind aber auch separate Signalverbindungen oder eine drahtlose Übertragung denkbar. Es ist ebenso denkbar, dass für das Empfangen eigene Lokalspulen oder andere Antennen vorgesehen sind.

Die erfindungsgemäße Vorrichtung 60 zur Rückgewinnung des zeitlichen Bezuges in einer freilaufenden MRT-Empfangskette ist in der beispielhaften Ausführungsform der Fig. 1 in der Hochfrequenzeinheit 22 angeordnet, es sind aber auch andere funktionale Aufteilungen denkbar, von denen einige nachfolgend beschrieben werden.

Fig. 2 zeigt ein schematisches Funktionsdiagramm einer erfindungsgemäßen Ausführungsform einer Vorrichtung 60 zur Rückgewinnung des zeitlichen Bezuges in einer freilaufenden MRT-Empfangskette. Zur Übersichtlichkeit sind in Fig. 2 nicht alle Elemente der Fig. 1 dargestellt. Gleiche Referenzzeichen bezeichnen gleiche Gegenstände.

Die Hochfrequenzeinheit 22 der Fig. 2 weist einen Zeitreferenzencoder 61 auf. In der dargestellten Ausführungsform erhält der Zeitreferenzencoder 61 einen Referenztakt von einem zentralen Taktgeber 24 der Steuerung 20 des Magnetresonanztomographen 1 über den Signalbus 25.

Der Zeitreferenzencoder 61 erzeugt ein Modulationssignal in Abhängigkeit von dem Referenztakt. Das Modulationssignal wird an einem ersten Ausgang des Zeitreferenzencoders 61 ausgegeben und einem Hochfrequenzgenerator 63 zugeführt, der eine Trägerwelle damit moduliert. Die Trägerwelle weist dabei vorzugsweise eine Frequenz nahe bei der Larmorfrequenz des Magnetresonanztomographen 1 oder im Bereich der Larmorfrequenz und des MRT-Signals des Magnetresonanztomographen 1. Die modulierte Trägerwelle wird in vorbestimmten Zeitabschnitten oder kontinuierlich über die Antenne 64 abgestrahlt, sodass die Lokalspule 50 bzw. die Lokalspulen 50 und/oder die Körperspule 14 die Trägerwelle empfangen kann.

Das von der Lokalspule 50 und/oder der Körperspule 14 aufgenommene Signal der Trägerwelle wird in der in Fig. 2 dargestellten Ausführungsform und gemäß der Erfindung von der Empfangskette der MR-Signale zur Bildgebung weiterverarbeitet. Es kann dabei eine Verstärkung, Filterung und/oder auch Umsetzung in einen anderen Frequenzbereich als Zwischenfrequenz erfolgen. Auch eine Digitalisierung durch einen A/D-Wandler ist denkbar. Auf diese Weise wird sichergestellt, dass das Signal der Trägerwelle den gleichen Weg wie ein MR-Signal durchläuft und alle Verarbeitungsschritte und die damit verbundenen Verzögerungen auf das Signal der Trägerwelle und das MR-Signal gleich einwirken.

Der Zeitreferenzencoder 21 erzeugt dabei ein Modulationssignal, das dazu geeignet ist, nach einer Übertragung durch die MRT-Empfangskette durch Korrelation mit einem Referenzsignal erkannt und bezüglich einer zeitlichen Verschiebung zu dem ürsprünglichen Modulationssignal zugeordnet zu werden. Da das Empfangssignal und das Referenzsignal das Modulationssignal aufweisen, kann dieser Vorgang auch als Autokorrelation für das Modulationssignal bezeichnet werden.

Als Modulationssignal eignen sich beispielsweise Pseudozufallsbitfolgen (pseudo random binary sequence, PRBS), die vorab erzeugt und in einem Speicher gespeichert werden oder durch eine Logikschaltung, beispielsweise durch ein rückgekoppeltes Linear-Schieberegister (Linear feedback shift register, LFSR) in Abhängigkeit von einem vorbestimmten Startwert, der Rückkopplung und dem Referenztakt in Echtzeit erzeugt werden. Dabei sind Bitfolgen unterschiedlicher Länge als Modulationssignal denkbar. Je länger eine verwendete Bitfolge ist, desto länger ist eine zeitliche Intervalldauer, für die durch die Bitfolge eindeutig ein Wert für die Verzögerung des Empfangssignals bestimmt werden kann. Gleichzeitig nimmt mit der Länge auch die Schärfe der Korrelationsfunktion zu. Die Korrelation $R_{12}(m)$ wird dabei durch das Integral bzw. die Summe (diskrete Werte) über das Produkt der Modulationsfunktion $s_1$ mit einer um einen Zeitraum $m$ verschobenen Modulationsfunktion $s_2$ berechnet

$$R_{12}(m) = \frac{1}{N} \sum_{n=0}^{N} s_1(n+m) s_2^*(n)$$

Beispiele von für das Modulationssignal geeigneten Pseudozufallsbitfolgen sind Gold-Folgen, Kasami-Folgen oder JPL-Folgen.

Die Modulation kann dabei auf unterschiedlichen Wegen erfolgen. Es ist beispielsweise denkbar, dass die Modulation schmalbandig erfolgt, sodass nur ein geringer Frequenzbereich belegt wird und die modulierte Trägerwelle zwar noch in einen Empfangsbereich der Lokalspule 50 und Hochfrequenzeinheit 22 fällt, aber nicht mit dem MR-Signal der Kernspins für die Bildgebung überlappt. Denkbar wären hier zum Beispiel Frequenz- oder Amplitudenmodulation.

Andererseits können auch breitbandige Modulationsverfahren zum Einsatz kommen, die ein gespreiztes Frequenzband (spread spectrum) verwenden, um die modulierte Information in einem breiten Frequenzbereich zu verteilen. Ein mögliches Beispiel für eine Frequenzspreizungsmodulation ist CDMA (code division multiple access), denkbar sind aber auch beispielsweise DSSS (direct sequence spread spectrum), FHSS (frequency hopping spread spectrum) oder CSS (chirp spread spectrum). Mit korrespondierenden Demodulationsverfahren auf der Empfängerseite ist es dabei möglich, auch Signale unterhalb des Rauschpegels zu empfangen. Wird also in einer bevorzugten Ausführungsform die Leistung der Trägerwelle derartig reduziert, dass der Empfangspegel in den Lokalspulen 50 bzw. der Bodycoil 14 unter einer Rauschgrenze des MR-Signals bleibt, kann die Trägerwelle permanent gesendet werden, ohne die Bildgebung negativ zu beeinflussen.

Es ist aber auch möglich, dass die erfindungsgemäße Vorrichtung 60 die modulierte Trägerwelle nur temporär aussendet. Beispielsweise ist es denkbar, dass eine Synchronisation der Empfangskette nur jeweils nach einer Anregung der Kernspins durch einen Hochfrequenzpuls erfolgt, bevor jeweils die MR-Signale der Kernspins durch die Empfangskette empfangen werden. Denkbar wäre auch ein wiederholtes aussenden der modulierten Trägerwelle beispielsweise bei FAST-Sequenzen ohne jeweilige Anregung. Bei einem derartigen temporären Aussenden wäre es auch denkbar, dass die Aussendung durch die Hochfrequenzeinheit 22 erfolgt, die auch die Anregungspulse erzeugt. Die Hochfrequenzeinheit 22 müsste dabei ausgelegt sein, eine mit dem Modulationssignal modulierte Trägerwelle ausreichend geringer Leistung zu erzeugen, um nicht die Empfangskette zu überlasten.

Im Zeitreferenzdecoder 62 oder durch einen vorgelagerten Demodulator erfolgt eine Demodulation des Empfangssignals der modulierten Trägerwelle. Die Demodulation erfolgt dabei komplementär zu der verwendeten Modulation. Bei einer Amplitudenmodulation beispielsweise durch eine Gleichrichtung des Hochfrequenzsignals, bei einer Frequenzmodulation beispielsweise durch einen Hoch- oder Tiefpass oder einen PLL und bei einer Frequenzspreizungsmodulation durch entsprechende Demodulatoren, z.B. mit einer Korrelation.

Durch die Demodulation wird das ursprüngliche Modulationssignal rekonstruiert. Bei einer Pseudozufallszahlenfolge kann beispielsweise mittels einer Korrelation einer Referenz-Pseudozufallszahlenfolge die zeitliche Position der empfangenen Pseudozufallszahlenfolge gegenüber dieser Referenz bestimmt und ein entsprechendes Verzögerungssignal erzeugt werden.

In der Fig. 2 sind dabei der bzw. die Zeitreferenzdecoder 62 in der zentralen Hochfrequenzeinheit 22 angeordnet, sodass beispielsweise alle Zeitreferenzdecoder 62 vorzugsweise mit einem zentralen Takt von einem zentralen Taktgeber 24 und synchron aus einer gemeinsamen Quelle mit einer Referenz-Pseudozufallszahlenfolge versorgt werden können, bzw. einem gemeinsamen Referenz-Modulationssignal. Es ist aber auch denkbar, dass das Modulationssignal in dem Zeitreferenzdecoder 62 gespeichert oder lokal durch eine Logik erzeugt wird.

In einer bevorzugten Ausführungsform sind der bzw. die Zeitreferenzdecoder 62 als Funktion in einer Signalverarbeitung eines digitalen Empfängers realisiert. Es sind aber auch separate Zeitreferenzdecoder 62 denkbar, die das Empfangssignal auswerten und beispielsweise als analoge Schaltkreise, programmierte Logikschaltungen, Signalprozessoren oder Kombinationen davon realisiert sind.

Vorzugsweise ist die Steuerung 23 ausgelegt, das erzeugte Verzögerungssignal bei einer Verarbeitung von MR-Signalen zu einer Abbildung zu berücksichtigen. Beispielsweise ist es denkbar, die Phasen der empfangenen MR-Signale entsprechend zu korrigieren.

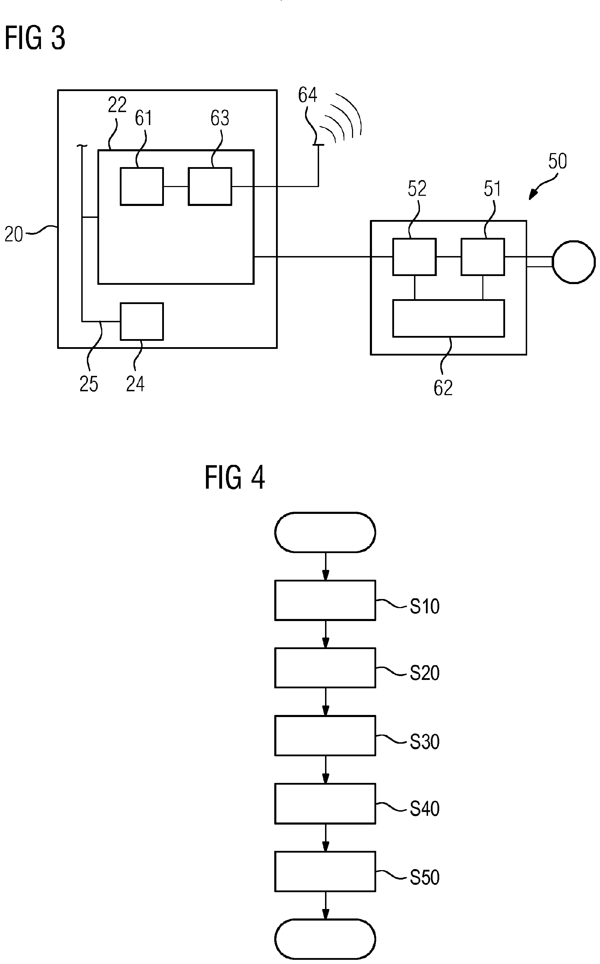

Fig. 3 zeigt eine andere mögliche Ausführungsform einer erfindungsgemäßen Vorrichtung zur Rückgewinnung des zeitlichen Bezuges in einer freilaufenden MRT-Empfangskette. Gleiche Gegenstände sind wieder mit gleichen Referenzzeichen bezeichnet. Wie bei Fig. 2 sind auch hier nicht alle Elemente der Fig. 1 dargestellt.

Die Ausführungsform der Fig. 3 unterscheidet sich vor allem dadurch von der Fig. 2, dass der bzw. die Zeitreferenzdecoder 62 nicht in der zentralen Hochfrequenzeinheit 22, sondern in der bzw. den Lokalspulen 50 vorgesehen ist.

In der Ausführungsform der Fig. 3 weist dazu der Zeitreferenzdecoder 62 jeweils eine eigene Quelle für ein Referenz-Modulationssignal auf, beispielsweise einen Speicher, in dem die Pseudozufallszahlenfolge gespeichert ist oder eine Logikschaltung, die die Pseudozufallszahlenfolge vor Ort erzeugt. Nach einer Verstärkung des empfangenen Signals durch einen Vorverstärker (low noise amplifier LNA) wird dieses dem Signalreferenzdecoder 62 zur Auswertung über eine Signalverbindung zugeführt. Der Signalreferenzdecoder 62 erzeugt daraus ein Signal, das einen zeitlichen Bezug zu dem Referenz-Modulationssignal angibt.

In einer möglichen Ausführungsform der Fig. 3 erfolgt in einem Umsetzer 52 der Lokalspule 50 eine Digitalisierung des empfangenen MR-Signals. Der Zeitreferenzdecoder 62 fügt dem Empfangssignal einen Zeitstempel hinzu, der anhand der empfangenen modulierten Trägerwelle eine zeitliche Relation der aus dem Empfangssignal erzeugten Daten in Bezug auf das Referenz-Modulationssignal angibt und damit auch einen zeitlichen Bezug zu einem mit der Trägerwelle übertragenen zentralen Takt. Auf diese Weise können in einer nachfolgenden Bildgebung die unterschiedlichen zeitlichen Verzögerungen, beispielsweise für unterschiedliche Lokalspulen 50, in der Bildgebung berücksichtigt werden. Je nach verwendetem Modulationssignal kann dabei ein Zeitfenster vorgegeben werden, innerhalb dessen der Zeitstempel eindeutig ist. Bei größeren Längen z.B. der Pseudozufallszahlenfolge können so auch größere Unterschiede der Verzögerung in den unterschiedlichen Empfangswege abgedeckt werden.

Es ist aber auch denkbar, dass der Zeitreferenzdecoder 62 ein bereits digitalisiertes Signal des Umsetzers 52 nützt und daher das empfangene und von dem Vorverstärker 51 verstärkte Signal von dem Umsetzer 52 erhält.

Zusätzlich oder alternativ ist es auch denkbar, dass der Zeitreferenzdecoder 62 einen Referenztakt aus dem von der Trägerwelle übertragenen Modulationssignal gewinnt. Bei geeigneter Wahl der Pseudozufallszahlenfolge ist es beispielsweise möglich, mittels eines Oszillators mit Phasenrückkoppelschleife (phase lock loop, PLL) den ursprünglichen Bit-Takt der Pseudozufallszahlenfolge zurückzugewinnen. Dieser Takt kann beispielsweise zur synchronen Digitalisierung mittels eines A/D-Wandlers genützt werden. Denkbar ist auch die Verwendung als lokalen Oszillator zur Umsetzung des Empfangssignals auf eine Zwischenfrequenz.

Fig. 4 zeigt einen schematischen Ablaufplan eines erfindungsgemäßen Verfahrens zur Rückgewinnung des zeitlichen Bezuges in einer freilaufenden MRT-Empfangskette.

In einem Schritt S10 wird ein Modulationssignal erzeugt. Das Modulationssignal ist zur Korrelation geeignet, d.h. es lässt sich mittels eines Referenz-Modulationssignals die zeitliche Lage eines zeitlich verschobenen Modulationssignals bestimmen. Das Modulationssignal kann beispielsweise in einem Speicher gespeichert sein und zur Erzeugung aus dem Speicher ausgelesen werden. Denkbar ist auch die Erzeugung aus einem Startwert mittels einer Logik, z.B. einem rückgekoppelten Linearschieberegister. Die Erzeugung erfolgt in Abhängigkeit von einem Referenztakt eines zentralen Taktgebers 24 mittels eines Zeitreferenzencoders 61. Es ist dabei auch denkbar, dass der zentrale Taktgeber 24 Teil des Zeitreferenzencoders 61 ist.

In einem anderen Schritt S20 wird eine Trägerwelle mittels eines Hochfrequenzgenerators 63 in Abhängigkeit von dem Referenztakt erzeugt. Denkbar ist beispielsweise ein Frequenzsynthesizer. Die Trägerwelle wird von dem Hochfrequenzgenerator 63 mit dem Modulationssignal moduliert, beispielsweise mittels Amplitudenmodulation, Frequenzmodulation oder Frequenzspreizungsmodulation.

In einem Schritt S30 wird die modulierte Trägerwelle über eine Antenne 64 ausgesendet.

In einem weiteren Schritt S40 wird die Trägerwelle mittels einer Empfangsantenne empfangen, beispielsweise einer Empfangsspule einer Lokalspule 50, an einen Empfänger weitergeleitet und von dem Empfänger ein Empfangssignal erzeugt.

In einem Schritt S50 wird ein zeitlicher Bezuge zwischen Empfangssignal und Referenztakt durch den Zeitreferenzdecoder 62 ermittelt. Dazu vergleicht der Zeitreferenzdecoder 62 ein Referenzsignal mittels Korrelation mit dem Empfangssignal und bestimmt auf diese Weise einen Zeitbezug zwischen Referenzsignal und dem empfangenen Modulationssignal. Schließlich gibt der Zeitreferenzdecoder 62 ein Zeitbezugssignal in Abhängigkeit von dem ermittelten zeitlichen Bezug aus.

In einem möglichen weiteren Schritt erfolgt eine Bildgebung durch eine Steuereinheit 20 in Abhängigkeit von dem Zeitbezugssignal.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

**Patentansprüche**

1.  Magnetresonanztomograph mit einer Vorrichtung zur Rückgewinnung des zeitlichen Bezuges in einer freilaufenden MRT-Empfangskette, wobei die Vorrichtung einen Zeitreferenzencoder (61) mit einem ersten Signalausgang und einen Zeitreferenzdecoder (62) mit einem ersten Signaleingang aufweist, wobei der Zeitreferenzencoder (61) ausgelegt ist, ein Modulationssignal in Abhängigkeit von einem Referenztakt zur Modulation einer Trägerwelle zu erzeugen und über den ersten Signalausgang auszugeben, wobei das Modulationssignal für eine Korrelation mit einer zeitlichen Auflösung kleiner einer maximalen vorbestimmten Phasenabweichung und einem eindeutig zu identifizierendes Maximum ausgelegt ist,

> wobei der Magnetresonanztomograph (1) eine zentrale Takterzeugung und der Zeitreferenzencoder (61) einen Referenzsignaleingang aufweist, wobei der Referenzsignaleingang des Zeitreferenzencoders (61) mit dem zentralen Takterzeuger in Signalverbindung steht, um den Referenztakt zu erhalten;
> wobei der Magnetresonanztomograph (1) einen Hochfrequenzgenerator (63) aufweist, der ausgelegt ist, die Trägerwelle in Abhängigkeit von dem zentralen Taktgeber zu erzeugen und in Abhängigkeit von dem Modulationssignal zu modulieren,
> wobei der Magnetresonanztomograph (1) eine Sendeantenne zum Aussenden der Trägerwelle und eine Empfangsantenne und einen Empfänger der MRT-Empfangskette aufweist, der zum Empfang von MR-Signalen zur Bildgebung, zum Empfang der Trägerwelle und zum Erzeugen des Empfangssignals ausgelegt ist, wobei der Empfänger in Signalverbindung mit dem Zeitreferenzdecoder (62) steht und ausgelegt ist, dem ersten Signaleingang des Zeitreferenzdecoders (62) das Empfangssignal zuzuführen,
> wobei der Zeitreferenzdecoder (62) ausgelegt ist, über den ersten Signaleingang das Empfangssignal in Abhängigkeit von dem Modulationssignal zu empfangen, wobei das Empfangssignal von dem Empfänger stammt, der die mit dem Modulationssignal des Zeitreferenzencoders modulierte Trägerwelle empfängt, wobei der Zeitreferenzdecoder (62) ausgelegt ist, eine Korrelation des Empfangssignals mit einem Referenzsignal auszuführen und ein Signal in Abhängigkeit von einem zeitlichen Bezug des Modulationssignals in dem Empfangssignal zu dem Referenzsignal zu generieren, wobei das Modulationssignal für eine Korrelation mit einer zeitlichen Auflösung kleiner einer maximalen vorbestimmten Phasenabweichung ausgelegt ist, indem das Modulationssignal und das Referenzsignal jeweils eine Grundfrequenzkomponente mit einer Periodendauer kleiner einer Mikrosekunde aufweist, wobei das Modulationssignal so ausgelegt ist, dass es bei einer Korrelation mit dem Referenzsignal ein eindeutig zu identifizierendes Maximum aufweist, wobei die Korrelation ein Maximum bei zeitlicher Übereinstimmung von Modulationssignal und dem Referenzsignal aufweist, das beim Vorliegen eines Nebenmaximums in der Amplitude mehr als 6 dB über einer Amplitude bei dem Nebenmaximum und beim Vorliegen mehrerer Nebenmaxima in der Amplitude mehr als 6 dB über den Amplituden bei den Nebenmaxima bei einem zeitlichen Versatz des Modulationssignals zu dem Referenzsignal ist, indem das Modulationssignal und das Referenzsignal jeweils eine Länge größer als 10 Perioden der Grundfrequenzkomponente aufweist.

2. Magnetresonanztomograph nach Anspruch 1, wobei der Zeitreferenzencoder (61) einen Pseudozufallsfolgengenerator zur Erzeugung des Modulationssignals aufweist.

3. Magnetresonanztomograph nach Anspruch 2, wobei der Pseudozufallsfolgengenerator eine Schieberegisterlogik mit linearer Rückkopplung aufweist.

4. Magnetresonanztomograph nach Anspruch 2, wobei der Pseudozufallsfolgengenerator ausgelegt ist eine Gold-, Kasami- oder JPL-Folge zu erzeugen

5. Magnetresonanztomograph nach einem der Ansprüche 2 bis 4, wobei der Zeitreferenzdecoder (62) einen PLL-gesteuerten frequenzvariablen Oszillator aufweist, wobei der Oszillator ausgelegt ist, ein Taktsignal des Pseudozufallsfolgengenerators zurückzugewinnen.

6. Magnetresonanztomograph nach Anspruch 1, wobei die Trägerwelle eine Frequenz in einem Frequenzbereich einer Larmorfrequenz des Magnetresonanztomographen (1), insbesondere der Larmorfrequenz eines Wasserstoffkerns liegt.

7. Magnetresonanztomograph nach Anspruch 6, wobei der Hochfrequenzgenerator (63) ausgelegt ist, die Trägerwelle mit dem Modulationssignal mittels einer Frequenzspreizungsmodulation zu modulieren.

8. Magnetresonanztomograph nach einem der Ansprüche 1, 6 oder 7, wobei der Magnetresonanztomograph (1) eine Lokalspule (50) mit einem Zeitreferenzdecoder (62) nach einem der Ansprüche 1 bis 5 aufweist.

9. Magnetresonanztomograph nach einem der Ansprüche 7 oder wobei der Magnetresonanztomograph (1) eine Mehrzahl an Empfängern zum Empfang eines Magnetresonanzsignals aufweist und eine Mehrzahl an Zeitreferenzdecodern (62) in Signalverbindung mit jeweils einem Empfänger.

10. Verfahren zur Rückgewinnung des zeitlichen Bezuges in einer freilaufenden MRT-Empfangskette eines Magnetresonanztomographen (1) nach Anspruch 1, wobei das Verfahren die Schritte aufweist:

(S10) Erzeugen des Modulationssignals zur Korrelation in Abhängigkeit von dem Referenztakt des zentralen Taktgebers mittels des Zeitreferenzencoders (61);
(S20) Erzeugen der Trägerwelle mittels des Hochfrequenzgenerators (63) in Abhängigkeit von dem Referenztakt und Modulieren mit dem Modulationssignal, wobei das Modulationssignal für eine Korrelation mit einer zeitlichen Auflösung kleiner einer maximalen vorbestimmten Phasenabweichung ausgelegt ist, indem das Modulationssignal und das Referenzsignal jeweils eine Grundfrequenzkomponente mit einer Periodendauer kleiner einer Mikrosekunde aufweist;
(S30) Aussenden der modulierten Trägerwelle über die Sendeantenne (64) ;
(S40) Empfangen der Trägerwelle mittels der Empfangsantenne und Erzeugen des Empfangssignals mittels des Empfängers der MRT-Empfangskette;
(S50) Ermitteln des zeitlichen Bezuges zwischen Empfangssignal und Referenzsignal durch den Zeitreferenzdecoder (62) mittels Korrelationsberechnung, wobei das Modulationssignal so ausgelegt ist, dass es bei der Korrelation mit dem Referenzsignal ein eindeutig zu identifizierendes Maximum aufweist, wobei die Korrelation ein Maximum bei zeitlicher Übereinstimmung von dem Modulationssignal und dem Referenzsignal aufweist, das beim Vorliegen eines Nebenmaximums in der Amplitude mehr als 6 dB über einer Amplitude bei dem Nebenmaximum und beim Vorliegen mehrerer Nebenmaxima in der Amplitude mehr als 6 dB über den Amplituden bei den Nebenmaxima bei einem zeitlichen Versatz des Modulationssignals dem Referenzsignal ist, indem das Modulationssignal und das Referenzsignal jeweils ine Länge größer als 10 Perioden der Grundfrequenzkomponente aufweist, durch Ausgeben eines Zeitbezugssignals in Abhängigkeit von dem ermittelten zeitlichen Bezug.

11. Verfahren nach Anspruch 10, wobei der Magnetresonanztomograph (1) in einem weiteren Schritt eine Bildauswertung in Abhängigkeit von dem Zeitbezugssignal ausführt.

12. Computerprogrammprodukt, welches direkt in einen Prozessor einer programmierbaren Steuerung (23) eines Magnetresonanztomographen nach einem der Ansprüche 1 bis 9 ladbar ist, mit Programmcode-Mitteln, um alle Schritte eines Verfahrens nach einem der Ansprüche 10 oder 11 auszuführen, wenn das Programmprodukt auf der Steuerung (23) ausgeführt wird.

13. Computerlesbares Speichermedium mit darauf gespeicherten elektronisch lesbaren Steuerinformationen, welche derart ausgestaltet sind, dass sie bei Verwendung des Speichermediums in einer Steuerung (23) eines Magnetresonanztomographen (1) nach Anspruch 1 bis 9 das Verfahren nach einem der Ansprüche 10 oder 11 durchführen.

**Claims**

1. Magnetic resonance tomography system with a device for recovering the temporal reference in a free-running MRT receive chain, wherein the device has a time reference encoder (61) having a first signal output and a time reference decoder (62) having a first signal input,

   wherein the time reference encoder (61) is configured to generate a modulation signal as a function of a reference clock for modulation of a carrier wave and to output it via the first signal output, wherein the modulation signal is configured for a correlation with a temporal resolution less than a maximum predetermined phase deviation and a maximum that can clearly be identified;
   wherein the magnetic resonance tomography system (1) has a central clock generation and the time reference encoder (61) has a reference signal input, wherein the reference signal input of the time reference encoder (61) has a signal link to the central clock generator in order to obtain the reference clock;
   wherein the magnetic resonance tomography system (1) has a radio frequency generator (63) which is configured to generate the carrier wave as a function of the central clock and to modulate it as a function of the modulation signal,
   wherein the magnetic resonance tomography system (1) has a transmitting antenna for transmitting the carrier wave and a receiving antenna and a receiver of the MRT receive chain, which is configured for receiving MR signals for imaging, for receiving the carrier wave and for generating the receive signal, wherein the receiver has a signal link to the time reference decoder (62) and is configured to supply the receive signal to the first signal input of the time reference decoder (62),
   wherein the time reference decoder (62) is configured to receive, via the first signal input, the receive signal as a function of the modulation signal, wherein the receive signal originates from a receiver, which receives the carrier wave modulated with the modulation signal of the time reference encoder, wherein the time reference decoder (62) is configured to perform a correlation of the receive signal with a reference signal and to generate a signal as a function of a temporal reference of the modulation signal in the receive signal in relation to the reference signal, wherein the modulation signal is configured for a correlation with a temporal resolution less than a maximum predetermined phase deviation by the modulation signal and the reference signal each having a basic frequency component with a period duration less than one microsecond, wherein the modulation signal is configured such that, with a correlation with the reference signal, it has a maximum that can clearly be identified, wherein the correlation has a maximum if the modulation signal and the reference signal temporally match, which maximum, when one secondary maximum is present, has an amplitude more than 6 dB above an amplitude for the secondary maximum and, when a plurality of secondary maxima are present, has an amplitude more than 6bB above the amplitudes for the secondary maxima, with a temporal offset of the modulation signal in relation to the reference signal, by the modulation signal and the reference signal each having a length longer than 10 periods of the basic frequency component.

2. Magnetic resonance tomography system according to claim 1, wherein the time reference encoder (61) has a pseudo-random binary sequence generator in order to generate the modulation signal.

3. Magnetic resonance tomography system according to claim 2, wherein the pseudo-random binary sequence generator has a shift register logic circuit with linear feedback.

4. Magnetic resonance tomography system according to claim 2, wherein the pseudo-random binary sequence generator is configured to generate a gold, Kasami or JPL sequence.

5. Magnetic resonance tomography system according to one of claims 2 to 4, wherein the time reference decoder (62) has a PLL-controlled frequency-variable oscillator, wherein the oscillator is configured to recover a clock signal of the pseudo-random binary sequence generator.

6. Magnetic resonance tomography system according to claim 1, wherein the carrier wave a frequency lies in a frequency range of a Larmor frequency of the magnetic resonance tomography system (1), in particular the Larmor frequency of a hydrogen nucleus.

7. Magnetic resonance tomography system according to claim 6, wherein the radio frequency generator (63) is configured to modulate the carrier wave with the modulation signal by means of frequency spreading modulation.

8. Magnetic resonance tomography system according to one of claims 1, 6 or 7, wherein the magnetic resonance tomography system (1) has a local coil (50) having a time reference decoder (62) according to one of claims 1 to 5.

9. Magnetic resonance tomography system according to one of claims 7 or 8, wherein the magnetic resonance tomography system (1) has a plurality of receivers for receiving a magnetic resonance signal and a plurality of time reference decoders (62) having a signal link to a receiver in each case.

10. Method for recovering the temporal reference in a free-running MRT receive chain of a magnetic resonance tomography system (1) according to claim 1, wherein the method has the following steps:

(S10) generating the modulation signal for correlation as a function of the reference clock of the central clock by means of the time reference encoder (61);
(S20) generating the carrier wave by means of the radio frequency generator (63) as a function of the reference clock and modulating with the modulation signal, wherein the modulation signal is configured for a correlation with a temporal resolution less than a maximum predetermined phase deviation by the modulation signal and the reference signal each having a basic frequency component with a period duration of less than one microsecond;
(S30) emitting the modulated carrier wave via the transmitting antenna (64);
(S40) receiving the carrier wave by means of the transmitting antenna and generating the receive signal by means of the receiver of the MRT receive chain;
(S50) determining the temporal reference between receive signal and reference signal by the time reference decoder (62) by means of correlation calculation, wherein the modulation signal is configured such that, with the correlation with the reference signal, it has a maximum that can clearly be identified, wherein the correlation has a maximum if the modulation signal and the reference signal temporally match, which maximum, when one secondary maximum is present, has an amplitude more than 6 dB above an amplitude for the secondary maximum and, when a plurality of secondary maxima are present, has an amplitude more than 6bB above the amplitudes for the secondary maxima, with a temporal offset of the modulation signal in relation to the reference signal, by the modulation signal and the reference signal each having a length longer than 10 periods of the basic frequency component, by outputting a time reference signal as a function of the determined temporal reference.

11. Method according to claim 10, wherein in a further step, the magnetic resonance tomography system (1) performs an image evaluation as a function of the time reference signal.

12. Computer program product, which can be loaded directly into a processor of a programmable controller (23) of a magnetic resonance tomography system (23) according to one of claims 1 to 9, having program code means in order to carry out all steps of a method according to one of claims 10 or 11 when the program product is run on the controller (23).

13. Computer-readable storage medium having electronically readable control information stored thereon, which is configured in such a way that it carries out the method according to one of claims 10 or 11 when the storage medium is used in a controller (23) of a magnetic resonance tomography system (1) according to claim 1 to 9.

**Revendications**

1. Tomodensitomètre à résonnance magnétique comprenant un dispositif de récupération de la référence temporelle dans une chaîne de réception à TRM libre, dans lequel le dispositif a un codeur (61) de référence temporelle ayant une première sortie de signal et un décodeur (62) de référence temporelle ayant une première entrée de signal, dans lequel le codeur (61) de référence temporelle est conçu pour produire et pour donner, par la première sortie de signal, un signal de modulation en fonction d'une cadence de référence pour la modulation d'une onde porteuse, dans lequel le signal de modulation est conçu pour une corrélation à une résolution temporelle plus petite qu'un déphasage maximum déterminé à l'avance et un maximum à identifier de manière univoque,

dans lequel le tomodensitomètre (1) à résonnance magnétique a une production de cadence centrale et le codeur (61) de référence temporelle a une entrée de signal de référence, dans lequel l'entrée de signal de référence du codeur (61) de référence temporelle est en liaison de signal avec l'horloge centrale, afin d'obtenir la cadence de référence, dans lequel le tomodensitomètre (1) à résonnance magnétique a un générateur (63) en haute fréquence, qui est conçu pour produire l'onde porteuse en fonction de l'horloge centrale et pour la moduler en fonction du signal de modulation,

dans lequel le tomodensitomètre (1) à résonnance magnétique a une antenne d'émission pour l'émission de l'onde porteuse et une antenne de réception et un récepteur de la chaîne de réception TRM, qui est conçue pour la réception de signaux RM pour l'imagerie pour la réception de l'onde porteuse et pour la production du signal de réception, dans lequel

le récepteur est en liaison du signal avec le décodeur (62) de référence temporelle et est conçu pour envoyer le signal de réception à la première entrée du signal du décodeur (62) de référence temporelle,

dans lequel le décodeur (62) de référence temporelle est conçu pour recevoir, par la première entrée du signal, le signal de réception en fonction du signal de modulation, dans lequel le signal de réception provient du récepteur, qui reçoit l'onde porteuse modulée par le signal de modulation du codeur de référence temporelle, dans lequel le décodeur (62) de référence temporelle est conçu pour exécuter une corrélation du signal de réception à un signal de référence et pour créer un signal en fonction d'une référence temporelle du signal de modulation dans le signal de réception par rapport au signal de référence, dans lequel

le signal de modulation est conçu pour une corrélation à une résolution temporelle plus petite qu'un écart de phase maximum déterminé à l'avance, par le fait que le signal de modulation et le signal de référence ont chacun une composante de fréquence fondamentale d'une période plus petite qu'une microseconde, dans lequel le signal de modulation est conçu de manière à avoir, lors d'une corrélation avec le signal de référence, un maximum à identifier de façon univoque, dans lequel la corrélation a un maximum à une coïncidence temporelle du signal de modulation et du signal de référence, qui est, en présence d'un maximum secondaire, dans l'amplitude de plus de 6 dB au-delà d'une amplitude du maximum secondaire et, en présence de plusieurs maximums secondaires, dans l'amplitude de plus de 6 dB au-delà des amplitudes des maximums secondaires, lors d'un décalage temporel du signal de modulation par rapport au signal de référence, par le fait que le signal de modulation et le signal de référence ont chacun une longueur plus grande que 10 périodes de la composante de fréquence fondamentale.

2. Tomodensitomètre à résonnance magnétique suivant la revendication 1, dans lequel le décodeur (61) de référence temporelle a un générateur de suites pseudo-aléatoires pour la production du signal de modulation.

3. Tomodensitomètre à résonnance magnétique suivant la revendication 2, dans lequel le générateur de séquences pseudo-aléatoires a une logique à registre à décalage à réaction linéaire.

4. Tomodensitomètre à résonnance magnétique suivant la revendication 2, dans lequel le générateur de séquence pseudo-aléatoire est conçu pour produire une séquence gold, kasami ou JPL.

5. Tomodensitomètre à résonnance magnétique suivant l'une des revendications 2 à 4, dans lequel le décodeur (62) de référence temporelle a un oscillateur variable en fréquence à commande PLL, dans lequel l'oscillateur est conçu pour récupérer un signal de cadence du générateur de séquences pseudo-aléatoires.

6. Tomodensitomètre à résonnance magnétique suivant la revendication 1, dans lequel l'onde porteuse a une fréquence dans une plage de fréquences d'une fréquence de Larmor du tomodensitomètre (1) à résonnance magnétique, en particulier de la fréquence de Larmor d'un noyau d'hydrogène.

7. Tomodensitomètre à résonnance magnétique suivant la revendication 6, dans lequel le générateur (63) en haute fréquence est conçu pour moduler l'onde porteuse par le signal de modulation au moyen d'une modulation à étalement de fréquence.

**8.** Tomodensitomètre à résonnance magnétique suivant l'une des revendications 1, 6 ou 7, dans lequel le tomodensitomètre (1) à résonnance magnétique à une bobine (50) locale ayant un décodeur (62) de référence temporelle suivant l'une des revendications 1 à 5.

**9.** Tomodensitomètre à résonnance magnétique suivant l'une des revendications 7 ou 8, dans lequel le tomodensitomètre (1) à résonnance magnétique a une pluralité de récepteurs pour la réception d'un signal de résonnance magnétique et une pluralité de décodeurs (62) de référence temporelle en liaison du signal avec respectivement un récepteur.

**10.** Procédé de récupération de la référence temporelle dans une chaîne de réception à TRM libre d'un tomodensitomètre (1) à résonnance magnétique suivant la revendication 1, dans lequel le procédé a les stades :

    (S10) production du signal de modulation pour la corrélation en fonction de la cadence de référence de l'horloge centrale au moyen du codeur (61) de référence temporelle ;
    (S20) production de l'onde porteuse au moyen du générateur (63) en haute fréquence en fonction de la cadence de référence et modulation par le signal de modulation, dans lequel le signal de modulation est conçu pour une corrélation à une résolution temporelle plus petite qu'un déphasage maximum déterminé à l'avance, par le fait que le signal de modulation et le signal de référence ont chacun une composante de fréquence fondamentale d'une période plus petite qu'une microseconde ;
    (S30) envoi de l'onde porteuse modulée par l'antenne (64) d'émission ;
    (S40) réception de l'onde porteuse au moyen de l'antenne de réception et production du signal de réception au moyen du récepteur de la chaîne de réception à TRM ;
    (S50) détermination de la référence temporelle entre le signal de réception et le signal de référence par le décodeur (62) de référence temporelle au moyen d'un calcul de corrélation, dans lequel le signal de modulation est conçu de manière à avoir, lors de la corrélation au signal de référence, un maximum à identifier de manière univoque, dans lequel la corrélation a un maximum à la coïncidence temporelle du signal de modulation et du signal de référence, qui est, en présence d'un maximum secondaire, dans l'amplitude de plus de 6 dB au-delà d'une amplitude du maximum secondaire et, en présence de plusieurs maximums secondaires, d'une l'amplitude de plus de 6 dB au-delà des amplitudes des maximums secondaires, lors d'un décalage temporel du signal de modulation par rapport au signal de référence, par le fait que le signal de modulation et le signal de référence ont chacun une longueur plus grande que 10 périodes de la composante de la fréquence fondamentale, par émission d'un signal de référence temporelle en fonction de la référence temporelle déterminée.

**11.** Procédé suivant la revendication 10, dans lequel le tomodensitomètre (1) à résonance magnétique exécute, dans un autre stade, une évaluation d'image en fonction de la référence temporelle.

**12.** Produit de programme d'ordinateur, qui peut être chargé directement dans un processeur d'une commande (23) programmable d'un tomodensitomètre à résonnance magnétique suivant l'une des revendications 1 à 9,
comprenant des moyens de code de programme pour exécuter tous les stades d'un procédé suivant l'une des revendications 10 ou 11, lorsqu'on exécute le produit de programme sur la commande (23).

**13.** Support de mémoire, déchiffrable par ordinateur, sur lequel sont mises en mémoire des informations de commande, déchiffrables électroniquement, qui sont conformées de manière à exécuter, lors de l'utilisation du support de mémoire dans une commande (23) d'un tomodensitomètre (1) à résonnance magnétique suivant la revendication 1 à 9, le procédé suivant l'une des revendications 10 ou 11.

FIG 1

FIG 2

FIG 3

FIG 4

**IN DER BESCHREIBUNG AUFGEFÜHRTE DOKUMENTE**

**In der Beschreibung aufgeführte Patentdokumente**

- DE 102013204705
- DE 102011076918
- DE 102012210827
- US 20110109316 A1
- US 7123009 B1
- WO 2015197720 A
- DE 102011006509 A1